# EUROPEAN PATENT APPLICATION

(11) **EP 4 678 714 A1**
(43) Date of publication of application: **14.01.2026**
(21) Application number: 24767008.6
(22) Date of filing: 29.02.2024
(51) Int. Cl.: C09K 11/64, C09K 11/08, H01L 33/50

(54) **METHOD FOR PRODUCING ALUMINOSILICATE-BASED PHOSPHOR, ALUMINOSILICATE-BASED PHOSPHOR, AND LIGHT-EMITTING DEVICE**

(30) Priority: 07.03.2023 JP 2023035078
(71) Applicant: University of Yamanashi, Kofu-shi, Yamanashi 400-8510 (JP)
(72) Inventor: KUBOTA, Koki, Kofu-shi, Yamanashi 400-8510 (JP); MIYAJIMA, Naoya, Kofu-shi, Yamanashi 400-8510 (JP); SAKANE, Hideto, Kofu-shi, Yamanashi 400-8510 (JP)
(74) Representative: Ziebig Hengelhaupt Intellectual Property Attorneys Patentanwaltskanzlei PartGmbB
(86) International application number: PCT/JP2024/007506
(87) International publication number: WO 2024/185638

(57) **Abstract**

The present invention aims to provide a phosphor having lower contents of a rare earth element and a transition metal than conventional phosphors, and a method for producing the same.

According to the present invention, provided is a method for producing an aluminosilicate-based phosphor, comprising: a first calcination step, a silanol group formation step, and a second calcination step, wherein: in the first calcination step, a raw material aluminosilicate having an SiO₄ tetrahedral structure is heated to form oxygen vacancies in the raw material aluminosilicate, thereby obtaining an aluminosilicate-based phosphor intermediate 1; in the silanol group formation step, a temperature of the aluminosilicate-based phosphor intermediate 1 is lowered, and the aluminosilicate-based phosphor intermediate 1 is brought into contact with water to form silanol groups, thereby obtaining an aluminosilicate-based phosphor intermediate 2; and in the second calcination step, the aluminosilicate-based phosphor intermediate 2 is heated to make the aluminosilicate-based phosphor intermediate 2 non-crystalline, thereby obtaining the aluminosilicate-based phosphor.

## Description

### Technical Field

The present invention relates to a method for producing an aluminosilicate-based phosphor, an aluminosilicate-based phosphor, and a light-emitting device.

### Background Art

Phosphors are used in various applications such as backlights for liquid crystal displays, automotive headlights, and general lighting fixtures. In particular, general lighting fixtures are indispensable in daily life. In recent years, incandescent lamps are being used less due to their high power consumption, and fluorescent lamps are also being phased out due to concerns about the environmental problems of mercury. Therefore, light-emitting diodes (LEDs) have come to be used in place of incandescent and fluorescent lamps. Generally, a white LED can be produced by encapsulating a phosphor that emits a complementary color, such as yellow, in a blue LED.

Many of the phosphors contained in white LEDs are inorganic compounds that include a host material and a dopant. The dopant functions as an emission center, and compounds of transition metal elements or rare earth elements are mainly used as dopants.

To date, various inorganic phosphors have been developed. Patent Literature 1 discloses an α-type sialon using divalent Eu ions as a dopant. Patent Literature 2 discloses a β-type sialon using Mn, Ce, and Eu as dopants. Patent Literature 3 discloses a photoluminescent material containing Ag. Patent Literature 4 discloses a rare-earth-free phosphor containing Ti and Mn.

### Citation List

### Patent Literature

Patent Literature 1: JP 3668770 B
Patent Literature 2: JP 3921545 B
Patent Literature 3: JP 2021-195425 A
Patent Literature 4: JP 2016-210986 A

### Summary of Invention

### Technical Problem

However, conventional inorganic phosphors contained at least one of transition metal elements and rare earth elements. Many transition metal elements are harmful to the human body and the environment, and the price of rare earth elements is prone to sharp increases because their producing countries are limited. In addition, actinides are generated during the refining of rare earth elements, making a large environmental impact. Furthermore, since the host materials in conventional inorganic phosphors such as the sialon disclosed in Patent Literatures 1 to 2 are generally nitrides or oxynitrides, there has been a problem that high energy is required for the synthesis of the host material.

The present invention has been made in view of such problems, and aims to provide a phosphor having lower contents of a rare earth element and a transition metal than conventional phosphors, and a method for producing the same.

### Solution to Problem

The present invention that can achieve the above object is as follows.
[1] A method for producing an aluminosilicate-based phosphor, comprising: a first calcination step, a silanol group formation step, and a second calcination step, wherein: in the first calcination step, a raw material aluminosilicate having an SiO₄ tetrahedral structure is heated to form oxygen vacancies in the raw material aluminosilicate, thereby obtaining an aluminosilicate-based phosphor intermediate 1; in the silanol group formation step, a temperature of the aluminosilicate-based phosphor intermediate 1 is lowered, and the aluminosilicate-based phosphor intermediate 1 is brought into contact with water to form silanol groups, thereby obtaining an aluminosilicate-based phosphor intermediate 2; and in the second calcination step, the aluminosilicate-based phosphor intermediate 2 is heated to make the aluminosilicate-based phosphor intermediate 2 non-crystalline, thereby obtaining the aluminosilicate-based phosphor.
[2] The method for producing an aluminosilicate-based phosphor of [1], wherein in the silanol group formation step, the temperature of the aluminosilicate-based phosphor intermediate 1 is lowered to less than 50°C.
[3] The method for producing an aluminosilicate-based phosphor of [1] or [2], wherein: a heating temperature of the raw material aluminosilicate in the first calcination step is 130°C to 600°C; and a heating temperature of the aluminosilicate-based phosphor intermediate 2 in the second calcination step is equal to or higher than the heating temperature of the raw material aluminosilicate in the first calcination step.
[4] The method for producing an aluminosilicate-based phosphor of any one of [1] to [3], wherein: a heating time in the first calcination step is at least 30 minutes, and: a heating time in the second calcination step is longer than the heating time in the first calcination step.
[5] The method for producing an aluminosilicate-based phosphor of any one of [1] to [4], wherein in the silanol group formation step, a moist gas containing moisture is brought into contact with the aluminosilicate-based phosphor intermediate 1.
[6] The method for producing an aluminosilicate-based phosphor of [5], wherein in the second calcination step, the aluminosilicate-based phosphor intermediate 2 is heated in the moist gas.
[7] The method for producing an aluminosilicate-based phosphor of [5] or [6], wherein the moist gas has a weight absolute humidity of greater than 23 g/kg (DA).
[8] An aluminosilicate-based phosphor, wherein: the aluminosilicate-based phosphor is non-crystalline; in an IR spectrum of the aluminosilicate-based phosphor measured by FT-IR, S1/S0 is 0.365 to 0.400 and S2/S0 is 0.085 to 0.090, where S1 is an absorption peak area derived from a νₛ vibration of Si-O-T observed at 1115 cm⁻¹ to 1190 cm⁻¹, S2 is an absorption peak area derived from a δ vibration of O-Si-O observed at 490 cm⁻¹ to 520 cm⁻¹, and S0 is an absorption peak area derived from a νₛ vibration of T-O-T observed at 950 cm⁻¹ to 1065 cm⁻¹; the aluminosilicate-based phosphor has only one g-value obtained when its electron spin resonance is measured; and the g-value is 2.002 to 2.005.
[9] A light-emitting device, comprising the aluminosilicate-based phosphor of [8] and a light-emitting body.
[10] The light-emitting device of [9], wherein the light-emitting body is a light-emitting element having an emission peak wavelength in a range of 250 nm to 480 nm.

As a result of diligent studies, the present inventors have found that an aluminosilicate-based phosphor exhibiting delayed fluorescence can be obtained by a simple process of calcining a raw material aluminosilicate, bringing it into contact with water, and then further calcining it, thereby leading to the completion of the present invention. Since the phosphor according to the present invention has a lower content of a transition metal element than conventional phosphors or contains no transition metal element, it is less harmful to the human body and the environment. In addition, since the phosphor according to the present invention has a lower content of a rare earth element than conventional phosphors or contains no rare earth element, it has a small environmental impact and can be produced at a low cost. Further, since the raw material aluminosilicate can be synthesized with low energy compared to nitrides and oxynitrides, the total energy required for the production of the phosphor of the present invention is suppressed to a low level, considering the energy required for the synthesis of the raw material.

### Brief Description of Drawings

Fig. 1 is a diagram showing some examples of secondary structural units of aluminosilicate.
Fig. 2 is a schematic diagram showing the configuration of an electric furnace 2 for calcination according to this embodiment.
Fig. 3 is an example of XRD patterns according to Examples and Comparative Examples.
Fig. 4 is a graph showing the results of a durability test of a white LED according to Examples.

### Description of Embodiments

Hereinafter, the present invention will be described in detail with reference to the drawings. The present invention is not limited thereto, and various modifications can be made without departing from the gist thereof.

### <Method for Producing Aluminosilicate-Based Phosphor>

The method for producing an aluminosilicate-based phosphor of the present invention includes a first calcination step, a silanol group formation step, and a second calcination step, and an aluminosilicate is used as a starting material.

### (Aluminosilicate)

As a starting material for producing the aluminosilicate-based phosphor of the present invention, an aluminosilicate having an SiO₄ tetrahedral structure is used. Aluminosilicate is a hydrous crystal having a structure in which a part of silicon (Si) atoms in a silicate is substituted with aluminum (Al) atoms. That is, aluminosilicate is a hydrous crystal having a three-dimensional network structure in which all vertices of TO₄ tetrahedra (where T represents a Si or Al atom, and O represents an oxygen atom) are shared. In addition, aluminosilicate contains cations that compensate for the positive charge lost by substituting a part of Si with Al. Examples of cations include alkali metal ions and alkaline earth metal ions.

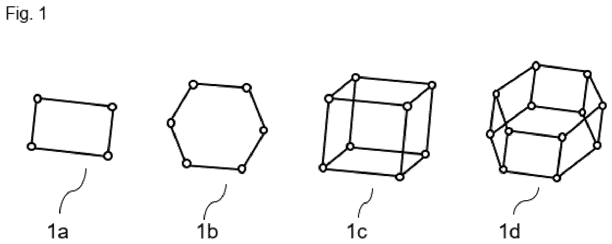

There are various types of aluminosilicates, and they are classified according to the difference in the connection mode (secondary structural unit) of the primary structural unit, the TO₄ tetrahedron. Fig. 1 shows some examples of the secondary structural units of aluminosilicate. In Fig. 1, 1a, 1b, 1c, and 1d schematically represent a single four-membered ring (S4R), a single six-membered ring (S6R), a double four-membered ring (D4R), and a double six-membered ring (D6R) that are the secondary structural units, respectively, and the white circles in the figure represent one TO₄ tetrahedron. It should be noted that these secondary structural units are examples, and it is known that various other secondary structural units exist. Aluminosilicate is constituted by the repetition of such secondary structural units.

In the present invention, the crystal structure of the aluminosilicate that is the starting material (raw material aluminosilicate) is not particularly limited, and examples thereof include X-type and Y-type crystal structures containing D6R as a secondary structural unit, and A-type crystal structures containing D4R. The raw material aluminosilicate according to an embodiment of the present invention preferably contains at least one of an aluminosilicate having an X-type crystal structure and an aluminosilicate having a Y-type crystal structure, and more preferably contains an aluminosilicate having a Y-type crystal structure.

In the present invention, the atomic ratio of Si to Al (Si/Al ratio) of the raw material aluminosilicate is also not particularly limited. The Si/Al ratio according to an embodiment of the present invention can be 1.0 or more, can be 1.0 to 2000, and is preferably 2.0 to 10. Specifically, the Si/Al ratio is, for example, 1.0, 1.5, 2.0, 2.1, 2.2, 2.3, 2.4, 2.5, 2.6, 2.7, 2.8, 2.9, 3.0, 3.1, 3.2, 3.3, 3.4, 3.5, 3.6, 3.7, 3.8, 3.9, 4.0, 5.0, 6.0, 7.0, 8.0, 9.0, 10, 20, 50, 100, 200, 500, 1000, 1200, 1400, 1600, 1800, or 2000, and may be in the range between the two numerical values exemplified herein.

The raw material aluminosilicate can be composed only of elements that are abundant on the earth. In addition, the raw material aluminosilicate can be synthesized easily with low energy by a conventionally known hydrothermal method. Therefore, the raw material aluminosilicate is inexpensive and easily available compared to raw materials for conventional inorganic phosphors.

### (First Calcination Step)

The first calcination step is a step of heating the raw material aluminosilicate to form oxygen vacancies in the raw material aluminosilicate, thereby obtaining an aluminosilicate-based phosphor intermediate 1. In the first calcination step, at least a part of the TO₄ tetrahedral structure of the raw material aluminosilicate is collapsed by calcination, Si-O bonds are broken, and oxygen vacancies are formed.

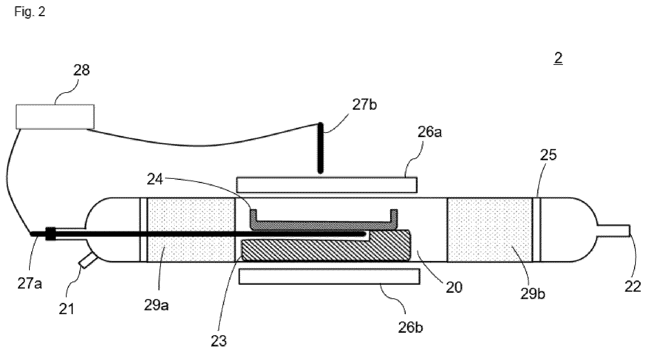

Fig. 2 is a schematic diagram showing the configuration of an electric furnace for calcination 2 according to this embodiment. As shown in Fig. 2, a furnace chamber 20 that can be substantially sealed is configured by a cylindrical quartz tube 25 and heat diffusion preventing inner lids 29a and 29b that close both ends thereof. The left end and the right end of the quartz tube 25 communicate with a gas inlet 21 and a gas outlet 22, respectively, via vent holes (not shown) provided in the heat diffusion preventing inner lids 29a and 29b, and are configured so that gas can be circulated in the furnace chamber 20. In addition, a boat stand 23 is present on the quartz tube 25 in the furnace chamber 20, and is configured so that an alumina boat 24, which is a heat-resistant boat, can be placed on the boat stand 23. Further, heaters 26a and 26b are disposed above and below the furnace chamber 20, and are configured so that a sample placed on the alumina boat 24 can be heated by supplying electric power to the heaters 26a and 26b. In addition, a data logger 28 is configured to be able to record the temperature of the furnace chamber 20 via thermocouples 27a and 27b, and can be used for temperature management. Examples of temperature management include feedback control that adjusts the electric power supplied to the heaters 26a and 26b according to the difference between the temperature of the furnace chamber 20 and a set temperature.

Hereinafter, the first calcination step will be described with reference to Fig. 2.

First, the raw material aluminosilicate is placed on a heat-resistant boat, for example, an alumina boat 24, and the alumina boat 24 is placed on a boat stand 23 in the calcination furnace. Next, an atmosphere gas is circulated in the furnace. The atmosphere gas can be an inert gas such as air, nitrogen, and argon, hydrogen, and a mixed gas thereof, and can also be any of air, nitrogen gas, hydrogen, and a mixed gas of nitrogen. Thereafter, the temperature in the furnace is raised from room temperature, and then heated at a constant temperature for a predetermined time. Instead of the electric furnace for calcination 2 shown in Fig. 2, a conventionally known heating means capable of performing the above series of processes may be used.

Hydrogen is a flammable gas, and its lower explosion limit is generally said to be 4.0 vol%. When oxygen, which is a combustion-supporting gas, is present at 5.0 vol% or more and the hydrogen concentration is equal to or higher than the lower explosion limit, there is a concern of explosion due to ignition. In particular, when the temperature exceeds 500°C under such an environment, there is also a concern of explosion due to spontaneous ignition. Therefore, in an embodiment of the present invention, when a mixed gas of air or an inert gas and hydrogen is used as the atmosphere gas, the hydrogen concentration is preferably 4.0 vol% or less, and it is more preferable to use a mixed gas of an inert gas and hydrogen. Specifically, the hydrogen concentration is, for example, 0.1, 0.5, 1.0, 1.5, 2.0, 2.5, 3.0, 3.5, or 4.0 vol%, and may be in the range between the two numerical values exemplified herein.

The amount of the raw material aluminosilicate is not particularly limited and can be arbitrarily selected. In an embodiment of the present invention, the amount of the raw material aluminosilicate charged into the calcination furnace depends on the size of the calcination furnace. As an example, it can be 0.1 to 10.0 g. Specifically, the amount of the raw material aluminosilicate is, for example, 0.1, 0.2, 0.5, 1.0, 2.0, 3.0, 4.0, 5.0, 6.0, 7.0, 8.0, 9.0, or 10.0 g, and may be in the range between the two numerical values exemplified herein.

The flow rate of the atmosphere gas to be circulated is not particularly limited. As an example, it can be 0.15 L/min or more, and is preferably 0.25 L/min to 1.0 L/min. Specifically, the flow rate of the atmosphere gas is, for example, 0.15, 0.20, 0.25, 0.30, 0.35, 0.40, 0.45, 0.50, 0.55, 0.60, 0.65, 0.70, 0.75, 0.80, 0.85, 0.90, 0.95, or 1.0 L/min, and may be in the range between the two numerical values exemplified herein.

The temperature increase rate from room temperature is not particularly limited and can be arbitrarily selected. Specifically, the temperature increase rate is, for example, 1, 2, 3, 4, 5, 10, 15, 20, 25, 30, 35, 40, 45, or 50°C/min, and may be in the range between the two numerical values exemplified herein. The heating temperature after the temperature increase is 130°C or higher, and preferably 130°C to 600°C. Specifically, the heating temperature after the temperature increase is, for example, 130, 140, 150, 160, 170, 180, 190, 200, 210, 220, 230, 240, 250, 260, 270, 280, 290, 300, 310, 320, 330, 340, 350, 360, 370, 380, 390, 400, 410, 420, 430, 440, 450, 460, 470, 480, 490, 500, 510, 520, 530, 540, 550, 560, 570, 580, 590, or 600°C, and may be in the range between the two numerical values exemplified herein. If the heating temperature is lower than 130°C, oxygen vacancies may not be sufficiently formed, and by setting the heating temperature to 600°C or lower, the amount of energy consumption can be suppressed. The heating time after the temperature increase is 30 minutes or longer, and preferably 30 minutes to 120 minutes. Specifically, the heating time after the temperature increase is, for example, 30, 40, 50, 60, 70, 80, 90, 100, 110, or 120 minutes, and may be in the range between the two numerical values exemplified herein. If the heating time is less than 30 minutes, oxygen vacancies may not be sufficiently formed, and by setting it to 120 minutes or less, the amount of energy consumption can be suppressed.

The formation of oxygen vacancies in the raw material aluminosilicate can be confirmed by comparing the IR spectrum (infrared absorption spectrum) of the raw material aluminosilicate with the IR spectrum of the aluminosilicate-based phosphor intermediate 1 or the aluminosilicate-based phosphor intermediate 2. As described later, when water comes into contact with the aluminosilicate-based phosphor intermediate 1, silanol groups are formed, and the aluminosilicate-based phosphor intermediate 2 is obtained. Therefore, when analyzing the aluminosilicate-based phosphor intermediate 1, it is ideally necessary to measure the IR spectrum without bringing the aluminosilicate-based phosphor intermediate 1 into contact with any water, but since water is generally present in the air, it is difficult to analyze the aluminosilicate-based phosphor intermediate 1 without going through the silanol group formation step. Since the formation of oxygen vacancies requires heating, and the oxygen vacancies contained in the aluminosilicate-based phosphor intermediate 2 that has undergone the first calcination step and the silanol group formation step are considered to have been formed in the first calcination step including heating, the formation of oxygen vacancies in the aluminosilicate-based phosphor intermediate 1 can be confirmed based on the IR spectrum of the aluminosilicate-based phosphor intermediate 2. Specifically, the absorption peaks derived from the νₛ vibration (symmetric stretching vibration) of Si-O-T observed at 1115 cm⁻¹ to 1190 cm⁻¹ and the δ vibration (bending vibration) of O-Si-O observed at 490 cm⁻¹ to 520 cm⁻¹ in the IR spectrum of the aluminosilicate-based phosphor intermediate 1 or the aluminosilicate-based phosphor intermediate 2 become broader and have lower intensity compared to the absorption peaks derived from the νₛ vibration of Si-O-T observed at 1115 cm⁻¹ to 1190 cm⁻¹ and the δ vibration of O-Si-O observed at 490 cm⁻¹ to 520 cm⁻¹ in the IR spectrum of the raw material aluminosilicate, thereby confirming the cleavage of Si-O bonds, that is, the formation of oxygen vacancies. Details of the IR spectrum will be described later.

The formation of oxygen vacancies in the raw material aluminosilicate can also be confirmed by the fact that the absorption peak derived from silanol groups observed at 930 cm⁻¹ to 950 cm⁻¹ in the IR spectrum of the aluminosilicate-based phosphor intermediate 2 has a higher intensity than the absorption peak derived from silanol groups observed at 930 cm⁻¹ to 950 cm⁻¹ in the IR spectrum of the raw material aluminosilicate. This is because if there are no oxygen vacancies in the aluminosilicate-based phosphor intermediate 1, no new silanol groups will be formed even if water comes into contact with the aluminosilicate-based phosphor intermediate 1. Details of silanol groups will be described later.

### (Silanol Group Formation Step)

The silanol group formation step is a step of lowering the temperature of the aluminosilicate-based phosphor intermediate 1 and bringing water into contact with the aluminosilicate-based phosphor intermediate 1 to form silanol groups, thereby obtaining an aluminosilicate-based phosphor intermediate 2. Silanol groups are formed by bringing water into contact with the oxygen vacancies formed in the first calcination step. The silanol group formation step needs to be performed at least once immediately after the first calcination step, and may be further performed immediately after each calcination step after the first calcination step, which will be described later.

First, the temperature of the aluminosilicate-based phosphor intermediate 1 is lowered. If the temperature is too high, silanol groups will not be sufficiently formed even if water is brought into contact with the aluminosilicate-based phosphor intermediate 1 by the method described later. Therefore, it is preferable to lower the temperature to less than 50°C. Specifically, this temperature is, for example, 15, 20, 25, 30, 35, 40, 41, 42, 43, 44, 45, 46, 47, 48, or 49°C, and may be in the range between the two numerical values exemplified herein. The cooling method is not particularly limited, and examples thereof include slow cooling by leaving it in the calcination furnace. The cooling rate is also not particularly limited, and for example, the cooling rate during slow cooling can be 1 to 50°C/min.

Next, silanol groups are formed by bringing water into contact with the cooled aluminosilicate-based phosphor intermediate 1. As a method for contacting with water, a method for directly pouring and adding pure water to the sample on the alumina boat taken out from the calcination furnace (water addition) and a method for circulating a moist gas containing moisture in the calcination furnace are mentioned.

Hereinafter, an embodiment of water addition will be described.

After lowering the temperature of the aluminosilicate-based phosphor intermediate 1 to a temperature suitable for the formation of silanol groups, the alumina boat is taken out from the calcination furnace. At this time, the circulation of the atmosphere gas in the furnace, which was performed in the first calcination step, is stopped. When the atmosphere around the taken-out alumina boat is air, moisture in the air comes into contact with the aluminosilicate-based phosphor intermediate 1. As a result, silanol groups are formed in at least some of the oxygen vacancies, and an aluminosilicate-based phosphor intermediate 2 is obtained. However, air may have low humidity (for example, weight absolute humidity of 23 g/kg (DA: dry air) or less), and the formation of silanol groups may be insufficient. It should be noted that when no moisture is contained in the atmosphere around the alumina boat, no silanol groups are formed, no aluminosilicate-based phosphor intermediate 2 is obtained, and the aluminosilicate-based phosphor intermediate 1 remains as it is. In this embodiment, pure water is directly poured onto the sample (aluminosilicate-based phosphor intermediate 1 or aluminosilicate-based phosphor intermediate 2) on the alumina boat, and then the alumina boat is placed on the boat stand in the furnace before the pure water evaporates. At this time, the weight absolute humidity of the atmosphere in the furnace exceeds 23 g/kg (DA), and more silanol groups are formed. In this way, an aluminosilicate-based phosphor intermediate 2 is obtained. The amount of pure water poured onto the sample is preferably an amount such that the weight absolute humidity of the atmosphere in the furnace exceeds 23 g/kg (DA), and more preferably almost the same amount as or more than the raw material aluminosilicate.

Hereinafter, a method for circulating a moist gas containing moisture in a calcination furnace and bringing it into contact with the aluminosilicate-based phosphor intermediate 1 will be described. In the present invention, moist gas means a gas containing moisture, and includes air and moist gas obtained by conventionally known means. The moist gas can be obtained, for example, by bubbling an atmosphere gas having a weight absolute humidity of less than 23 g/kg (DA) in pure water. The moist gas can be a gas with a weight absolute humidity of, for example, 10, 20, 21, 22, 23, 24, 25, 26, 27, 28, 29, 30, 30, 40, 50, 60, 70, 80, 90, or 100 g/kg (DA), and the weight absolute humidity may be in the range between the two numerical values exemplified herein.

In this embodiment, after the temperature of the aluminosilicate-based phosphor intermediate 1 is lowered to a temperature suitable for the formation of silanol groups, the atmosphere gas to be circulated in the furnace is switched to moist gas without taking the alumina boat out of the calcination furnace. Here, the weight absolute humidity of the atmosphere in the furnace can be more than 23 g/kg (DA), for example, 24, 25, 26, 27, 28, 29, 30, 40, 50, 60, 70, 80, 90, or 100 g/kg (DA), and may be in the range between the two numerical values exemplified herein. When the weight absolute humidity of the atmosphere in the furnace exceeds 23 g/kg (DA), silanol groups are sufficiently formed immediately, and an aluminosilicate-based phosphor intermediate 2 can be obtained. The flow rate of the moist gas to be circulated is not particularly limited, and is preferably 0.15 L/min or more, and more preferably 0.25 L/min to 1.0 L/min. Specifically, the flow rate of the moist gas is, for example, 0.15, 0.20, 0.25, 0.30, 0.35, 0.40, 0.45, 0.50, 0.55, 0.60, 0.70, 0.80, 0.90, or 1.0 L/min, and the weight absolute humidity may be in the range between the two numerical values exemplified herein.

In another embodiment of the present invention, air may be used as the moist gas, and a moist gas with a weight absolute humidity of 23 g/kg (DA) or less may also be used. The weight absolute humidity of the atmosphere in the furnace can be, for example, 10, 20, 21, 22, or 23 g/kg (DA), and the weight absolute humidity may be in the range between the two numerical values exemplified herein. For example, air that has not been bubbled is generally a moist gas with a weight absolute humidity of less than 23 g/kg (DA).

When using a moist gas with a weight absolute humidity of 23 g/kg (DA) or less, for example, air, which is a moist gas with a weight absolute humidity of 23 g/kg (DA) or less, may be circulated as the atmosphere gas in the first calcination step and used in the silanol group formation step without switching. When using a moist gas with a weight absolute humidity of less than 23 g/kg (DA), it is preferable to further perform a third calcination step after the second calcination step, as described later, in order to sufficiently form silanol groups.

The formation of new silanol groups in the silanol group formation step can be confirmed by comparing the IR spectrum of the raw material aluminosilicate or the IR spectrum of the aluminosilicate-based phosphor intermediate 1 with the spectrum of the aluminosilicate-based phosphor intermediate 2. Specifically, it can be confirmed by the fact that the absorption peak derived from silanol groups observed at 930 cm⁻¹ to 950 cm⁻¹ in the IR spectrum of the aluminosilicate-based phosphor intermediate 2 has a higher intensity than the absorption peak derived from silanol groups observed at 930 cm⁻¹ to 950 cm⁻¹ in the IR spectrum of the raw material aluminosilicate or the IR spectrum of the aluminosilicate-based phosphor intermediate 1. Details of the IR spectrum will be described later.

### (Second Calcination Step)

The second calcination step is a step of heating the aluminosilicate-based phosphor intermediate 2 to make the aluminosilicate-based phosphor intermediate 2 non-crystalline, thereby obtaining an aluminosilicate-based phosphor. Hereinafter, the second calcination step will be described.

After the silanol group formation step, the alumina boat on which the aluminosilicate-based phosphor intermediate 2 is placed is on the boat stand. Here, when water is added in the silanol group formation step, the atmosphere gas is not circulating in the furnace. On the other hand, when moist gas is circulated in the silanol group formation step, the moist gas is still circulating. From this state, the temperature in the furnace is raised from less than 50°C, and then heated at a constant temperature for a predetermined time. After heating, the temperature is lowered to room temperature. In this way, an non-crystalline aluminosilicate-based phosphor is obtained.

The temperature increase rate in the furnace is not particularly limited and can be arbitrarily selected. Specifically, the temperature increase rate is, for example, 1, 2, 3, 4, 5, 10, 15, 20, 25, 30, 35, 40, 45, or 50°C/min, and may be in the range between the two numerical values exemplified herein. The heating temperature after the temperature increase is 130°C or higher, preferably equal to or higher than the heating temperature of the first calcination step, and more preferably equal to or higher than the heating temperature of the first calcination step and 600°C or lower. Specifically, the heating temperature after the temperature increase is, for example, 130, 140, 150, 160, 170, 180, 190, 200, 210, 220, 230, 240, 250, 260, 270, 280, 290, 300, 310, 320, 330, 340, 350, 360, 370, 380, 390, 400, 410, 420, 430, 440, 450, 460, 470, 480, 490, 500, 510, 520, 530, 540, 550, 560, 570, 580, 590, or 600°C, and may be in the range between the two numerical values exemplified herein. By setting the heating temperature to 600°C or lower, the amount of energy consumption can be suppressed. The heating time after the temperature increase is at least 30 minutes or longer, preferably equal to or longer than the heating time of the first calcination step, and more preferably equal to or longer than the heating time of the first calcination step and 120 minutes or less. Specifically, the heating time after the temperature increase is, for example, 30, 40, 50, 60, 70, 80, 90, 100, 110, or 120 minutes, and may be in the range between the two numerical values exemplified herein. If the heating time is less than 30 minutes, oxygen vacancies may not be sufficiently formed, and by setting it to 120 minutes or less, the amount of energy consumption can be suppressed.

The method for cooling to room temperature is not particularly limited, and examples thereof include slow cooling by leaving it in the calcination furnace. The cooling rate is also not particularly limited. For example, the cooling rate during slow cooling can be 1 to 50°C/min.

### (Third Calcination Step)

The third calcination step is a step of further heating the aluminosilicate-based phosphor obtained in the second calcination step. In the silanol group formation step, when air with a weight absolute humidity of less than 23 g/kg (DA) is used as the moist gas, it is preferable to further perform the third calcination step. The process flow in the third calcination step is the same as in the second calcination step, and various conditions such as heating temperature, heating time, and cooling rate are preferably the same as in the second calcination step. In addition, the third calcination step may be performed multiple times. By performing the third calcination step, more silanol groups are formed, and the amorphization of the aluminosilicate-based phosphor proceeds further.

### <Aluminosilicate-Based Phosphor>

### (X-ray Diffraction Pattern)

The aluminosilicate-based phosphor obtained through the above steps is non-crystalline. In other words, the crystal structure (particularly the short-period structure) of the raw aluminosilicate is significantly collapsed. Therefore, in the X-ray diffraction (XRD) pattern of the aluminosilicate-based phosphor, the multiple peaks derived from the crystal structure (particularly the short-period structure) of the aluminosilicate become broader and the intensity of each peak becomes significantly lower than in the XRD pattern of the raw aluminosilicate. Specific examples of XRD patterns will be shown in the explanation of Examples below.

### (Infrared Absorption Spectrum)

When the infrared absorption spectrum (IR spectrum) of such an aluminosilicate-based phosphor is measured with a Fourier transform infrared spectrophotometer (FT-IR) and compared with the IR spectrum of the raw material aluminosilicate, significant differences are observed in multiple wavenumber regions. Specifically, the absorption peaks derived from the νₛ vibration (symmetric stretching vibration) of Si-O-T observed at 1115 cm⁻¹ to 1190 cm⁻¹ and the δ vibration (bending vibration) of O-Si-O observed at 490 cm⁻¹ to 520 cm⁻¹ in the IR spectrum of such an aluminosilicate-based phosphor become remarkably broader and have lower intensity compared to the IR spectrum of the raw material aluminosilicate. In addition, when the starting material is an aluminosilicate having D6R as a secondary structural unit (for example, Y-type aluminosilicate), an absorption peak derived from the v vibration (stretching vibration) of D6R is observed at 570 cm⁻¹ to 590 cm⁻¹. This absorption peak also becomes remarkably broader and has lower intensity compared to the IR spectrum of the raw material aluminosilicate. Such broad and low-intensity absorption peaks suggest that the collapse of the crystal structure of the raw material aluminosilicate proceeds during the production process of the aluminosilicate-based phosphor, that is, Si-O bonds are broken and oxygen vacancies are formed.

In the IR spectrum of the aluminosilicate-based phosphor, an absorption peak derived from the v vibration (stretching vibration) of a silanol group (Si-OH) is observed at 930 cm⁻¹ to 950 cm⁻¹. Since this absorption peak is not observed in the IR spectrum of the raw material aluminosilicate, it suggests that silanol groups are formed during the production process of the aluminosilicate-based phosphor. Such silanol groups are formed by the contact of water with oxygen vacancies, as described in the explanation of the method for producing the aluminosilicate-based phosphor above.

The area of each absorption peak in the IR spectrum can be normalized by the area of the absorption peak derived from the νₛ vibration (symmetric stretching vibration) of T-O-T observed at 950 cm⁻¹ to 1065 cm⁻¹. The normalized area of each absorption peak becomes part of the characteristics of the aluminosilicate-based phosphor of the present invention. For example, in the IR spectrum of an aluminosilicate-based phosphor produced using Y-type aluminosilicate as a raw material, when S1 is the absorption peak area derived from the νₛ vibration of Si-O-T observed at 1115 cm⁻¹ to 1190 cm⁻¹, S2 is the absorption peak area derived from the δ vibration of O-Si-O observed at 490 cm⁻¹ to 520 cm⁻¹, S3 is the absorption peak area derived from the v vibration of D6R observed at 570 cm⁻¹ to 590 cm⁻¹, S4 is the absorption peak area derived from the ν vibration of a silanol group observed at 930 cm⁻¹ to 950 cm⁻¹, and S0 is the absorption peak area derived from the νₛ vibration of T-O-T observed at 950 cm⁻¹ to 1065 cm⁻¹, S1/S0 is 0.365 to 0.400, S2/S0 is 0.085 to 0.090, S3/S0 is 0.127 to 0.134, and S4/S0 is 0.090 to 0.120. S1/S0 is, for example, 0.365, 0.366, 0.367, 0.368, 0.369, 0.370, 0.371, 0.372, 0.373, 0.374, 0.375, 0.376, 0.377, 0.378, 0.379, 0.380, 0.381, 0.382, 0.383, 0.384, 0.385, 0.386, 0.387, 0.388, 0.389, 0.390, 0.391, 0.392, 0.393, 0.394, 0.395, 0.396, 0.397, 0.398, 0.399, or 0.400, and may be in the range between the two numerical values exemplified herein. S2/S0 is, for example, 0.085, 0.086, 0.087, 0.088, or 0.089, and may be in the range between the two numerical values exemplified herein. S3/S0 is, for example, 0.127, 0.128, 0.129, 0.130, 0.131, 0.132, 0.133, or 0.134, and may be in the range between the two numerical values exemplified herein. S4/S0 is, for example, 0.090, 0.091, 0.092, 0.093, 0.094, 0.095, 0.096, 0.097, 0.098, 0.099, 0.100, 0.101, 0.102, 0.103, 0.104, 0.105, 0.106, 0.107, 0.108, 0.109, 0.110, 0.111, 0.112, 0.113, 0.114, 0.115, 0.116, 0.117, 0.118, 0.119, or 0.120, and may be in the range between the two numerical values exemplified herein.

### (Electron Spin Resonance)

The aluminosilicate-based phosphor of the present invention has only one g-value obtained when measured by electron spin resonance (ESR). In addition, this g-value is 2.002 to 2.005. The g-value is, for example, 2.002, 2.003, 2.004, or 2.005, and may be in the range between the two numerical values exemplified herein. Since the g-value of the E'_{δ} center, which is a type of oxygen vacancy, is known to be about 2.004, the g-value of the aluminosilicate-based phosphor of the present invention can be presumed to be mainly derived from the E'_{δ} center. Other oxygen vacancies include the E'₁ center and the non-bridging oxygen hole center (NBOHC). An aluminosilicate-based phosphor in which such oxygen vacancies are formed may have two or more g-values obtained when its ESR spectrum is measured, and may include a peak whose g-value is not 2.002 to 2.005.

### (Delayed Fluorescence)

The aluminosilicate-based phosphor of the present invention has the above-described characteristics in its XRD pattern, IR spectrum, and ESR spectrum. Such an aluminosilicate-based phosphor exhibits delayed fluorescence. Delayed fluorescence is a long-lived fluorescence that can be confirmed even after stopping the irradiation of the excitation light source to the phosphor. Generally, the fluorescence lifetime is 10 nanoseconds or less, but the delayed fluorescence lifetime is several orders of magnitude longer than that. The delayed fluorescence lifetime of the aluminosilicate-based phosphor of the present invention is on the order of milliseconds, and specifically, for example, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, or 100 milliseconds, and may be in the range between the two numerical values exemplified herein. Thus, delayed fluorescence is much longer than a typical fluorescence lifetime and is comparable to a phosphorescence lifetime of 1 microsecond to several tens of seconds.

### <Light-Emitting Device>

The aluminosilicate-based phosphor of the present invention is applicable to a light-emitting device that includes the aluminosilicate-based phosphor and a light-emitting body. The light-emitting device of the present invention includes the above-mentioned aluminosilicate-based phosphor and light-emitting body. The light-emitting body can be a light-emitting element having an emission peak wavelength in the range of 250 nm to 480 nm. When the light-emitting body is a light-emitting element such as an ultraviolet LED or a blue LED having an emission peak wavelength in the range of 250 nm to 480 nm, the aluminosilicate-based phosphor of the present invention emits white light with a broad peak at a wavelength of 400 nm to 575 nm. Therefore, the light-emitting device can be used as a white light-emitting device.

The use of the aluminosilicate-based phosphor of the present invention is not limited to light-emitting devices. For example, it can also be used as a fluorescent pigment for cosmetics, paints, inks, and the like.

### Examples

Hereinafter, specific embodiments of the present invention will be described in more detail with reference to Examples and Comparative Examples. The present invention is not limited in any way by the following Examples.

### <Example 1>

As a starting material, 1.0 g of commercially available NH₄-type Y-type zeolite manufactured by Sigma-Aldrich (product name: Molecular sieves, empirical formula: (NH₄) _{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and air was circulated in the furnace at a flow rate of 0.25 L/min. Thereafter, the temperature was raised from room temperature to 350°C at a temperature increase rate of 10°C/min and calcined at 350°C for 2 hours (first calcination step). After calcination, the sample was cooled to below 50°C, the alumina boat was removed from the electric furnace for calcination, and 1 ml of pure water was directly poured onto the sample on the alumina boat. The absorption peak derived from silanol groups observed at 930 cm⁻¹ to 950 cm⁻¹ in the IR spectrum of the obtained aluminosilicate-based phosphor intermediate 2 had a higher intensity compared to the absorption peak derived from silanol groups observed at 930 cm⁻¹ to 950 cm⁻¹ in the IR spectrum of the raw material aluminosilicate. Subsequently, the alumina boat was placed on the boat stand in the electric furnace for calcination before the pure water evaporated. Here, the weight absolute humidity inside the furnace is greater than 23 g/kg (DA). The phosphor of Example 1 was obtained by recalcination under the same conditions as the first calcination step and then cooling to room temperature.

### <Example 2>

As a starting material, 1.0 g of commercially available NH₄-type Y-type zeolite manufactured by Sigma-Aldrich (product name: Molecular sieves, empirical formula: (NH₄) _{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and nitrogen gas was circulated in the furnace at a flow rate of 0.25 L/min. Thereafter, the temperature was raised from room temperature to 350°C at a temperature increase rate of 10°C/min and calcined at 350°C for 2 hours (first calcination step). After calcination, the sample was cooled to below 50°C, the alumina boat was removed from the electric furnace for calcination, and 1 ml of pure water was directly poured onto the sample on the alumina boat. The absorption peak derived from silanol groups observed at 930 cm⁻¹ to 950 cm⁻¹ in the IR spectrum of the obtained aluminosilicate-based phosphor intermediate 2 had a higher intensity compared to the absorption peak derived from silanol groups observed at 930 cm⁻¹ to 950 cm⁻¹ in the IR spectrum of the raw material aluminosilicate. Subsequently, the alumina boat was placed on the boat stand in the electric furnace for calcination before the pure water evaporated. Here, the weight absolute humidity inside the furnace is greater than 23 g/kg (DA). The phosphor of Example 2 was obtained by recalcination under the same conditions as the first calcination step and then cooling to room temperature.

### <Example 3>

As a starting material, 1.0 g of commercially available NH₄-type Y-type zeolite manufactured by Sigma-Aldrich (product name: Molecular sieves, empirical formula: (NH₄)_{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and a mixed gas of 4% hydrogen/nitrogen (containing 4 vol% hydrogen and 96 vol% nitrogen) was circulated in the furnace at a flow rate of 0.25 L/min. Thereafter, the temperature was raised from room temperature to 350°C at a temperature increase rate of 10°C/min and calcined at 350°C for 2 hours (first calcination step). After calcination, the sample was cooled to below 50°C, the alumina boat was removed from the electric furnace for calcination, and 1 ml of pure water was directly poured onto the sample on the alumina boat. The absorption peak derived from silanol groups observed at 930 cm⁻¹ to 950 cm⁻¹ in the IR spectrum of the obtained aluminosilicate-based phosphor intermediate 2 had a higher intensity compared to the absorption peak derived from silanol groups observed at 930 cm⁻¹ to 950 cm⁻¹ in the IR spectrum of the raw material aluminosilicate. Subsequently, the alumina boat was placed on the boat stand in the electric furnace for calcination before the pure water evaporated. Here, the weight absolute humidity inside the furnace is greater than 23 g/kg (DA). The phosphor of Example 3 was obtained by recalcination under the same conditions as the first calcination step and then cooling to room temperature.

### <Example 4>

As a starting material, 1.0 g of commercially available NH₄-type Y-type zeolite manufactured by Sigma-Aldrich (product name: Molecular sieves, empirical formula: (NH₄) _{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and air was circulated in the furnace at a flow rate of 0.25 L/min. Thereafter, the temperature was raised from room temperature to 600°C at a temperature increase rate of 10°C/min and calcined at 600°C for 2 hours (first calcination step). After calcination, the sample was cooled to below 50°C, the alumina boat was removed from the electric furnace for calcination, and 1 ml of pure water was directly poured onto the sample on the alumina boat. The absorption peak derived from silanol groups observed at 930 cm⁻¹ to 950 cm⁻¹ in the IR spectrum of the obtained aluminosilicate-based phosphor intermediate 2 had a higher intensity compared to the absorption peak derived from silanol groups observed at 930 cm⁻¹ to 950 cm⁻¹ in the IR spectrum of the raw material aluminosilicate. Subsequently, the alumina boat was placed on the boat stand in the electric furnace for calcination before the pure water evaporated. Here, the weight absolute humidity inside the furnace is greater than 23 g/kg (DA). The phosphor of Example 4 was obtained by recalcination under the same conditions as the first calcination step and then cooling to room temperature.

### <Example 5>

As a starting material, 1.0 g of commercially available NH₄-type Y-type zeolite manufactured by Sigma-Aldrich (product name: Molecular sieves, empirical formula: (NH₄) _{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and nitrogen gas was circulated in the furnace at a flow rate of 0.25 L/min. Thereafter, the temperature was raised from room temperature to 350°C at a temperature increase rate of 10°C/min and calcined at 350°C for 2 hours (first calcination step). After calcination, the sample was cooled to below 50°C, and without removing the alumina boat from the electric furnace for calcination, nitrogen gas containing water vapor obtained by bubbling through water was circulated in place of the nitrogen gas that had been flowing. The absorption peak derived from silanol groups observed at 930 cm⁻¹ to 950 cm⁻¹ in the IR spectrum of the obtained aluminosilicate-based phosphor intermediate 2 had a higher intensity compared to the absorption peak derived from silanol groups observed at 930 cm⁻¹ to 950 cm⁻¹ in the IR spectrum of the raw material aluminosilicate. Here, the weight absolute humidity inside the furnace is greater than 23 g/kg (DA). Thereafter, the temperature was raised to 350°C at a temperature increase rate of 10°C/min, calcined at 350°C for 2 hours, and then cooled to room temperature to obtain the phosphor of Example 5.

### <Example 6>

As a starting material, 1.0 g of commercially available NH₄-type Y-type zeolite manufactured by Sigma-Aldrich (product name: Molecular sieves, empirical formula: (NH₄)_{6.64}Na₁₄₇Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and a mixed gas of 4% hydrogen/nitrogen (containing 4 vol% hydrogen and 96 vol% nitrogen) was circulated in the furnace at a flow rate of 0.25 L/min. Thereafter, the temperature was raised from room temperature to 350°C at a temperature increase rate of 10°C/min and calcined at 350°C for 2 hours (first calcination step). After calcination, the sample was cooled to below 50°C, and without removing the alumina boat from the electric furnace for calcination, a mixed gas of 4% hydrogen/nitrogen containing water vapor obtained by bubbling through water was circulated in place of the mixed gas of 4% hydrogen/nitrogen that had been flowing. The absorption peak derived from silanol groups observed at 930 cm⁻¹ to 950 cm⁻¹ in the IR spectrum of the obtained aluminosilicate-based phosphor intermediate 2 had a higher intensity compared to the absorption peak derived from silanol groups observed at 930 cm⁻¹ to 950 cm⁻¹ in the IR spectrum of the raw material aluminosilicate. Here, the weight absolute humidity inside the furnace is greater than 23 g/kg (DA). Thereafter, the temperature was raised to 350°C at a temperature increase rate of 10°C/min, calcined at 350°C for 2 hours, and then cooled to room temperature to obtain the phosphor of Example 6.

### <Example 7>

As a starting material, 1.0 g of commercially available NH₄-type Y-type zeolite manufactured by Sigma-Aldrich (product name: Molecular sieves, empirical formula: (NH₄)_{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and air was circulated in the furnace at a flow rate of 0.25 L/min. Thereafter, the temperature was raised from room temperature to 350°C at a temperature increase rate of 10°C/min and calcined at 350°C for 2 hours (first calcination step). After calcination, the sample was cooled to below 50°C. The absorption peak derived from silanol groups observed at 930 cm⁻¹ to 950 cm⁻¹ in the IR spectrum of the obtained aluminosilicate-based phosphor intermediate 2 had a higher intensity compared to the absorption peak derived from silanol groups observed at 930 cm⁻¹ to 950 cm⁻¹ in the IR spectrum of the raw material aluminosilicate. Here, the weight absolute humidity inside the furnace is less than 23 g/kg (DA). Next, without removing the alumina boat from the electric furnace for calcination, the sample was recalcined under the same conditions as the first calcination step. After this calcination, the sample was cooled to below 50°C. Thereafter, the phosphor of Example 7 was obtained by again recalcining under the same conditions as the first calcination step without removing the alumina boat from the electric furnace for calcination, and then cooling to room temperature.

### <Example 8>

As a starting material, 1.0 g of commercially available NH₄-type Y-type zeolite manufactured by Sigma-Aldrich (product name: Molecular sieves, empirical formula: (NH₄)_{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and air was circulated in the furnace at a flow rate of 0.25 L/min. Thereafter, the temperature was raised from room temperature to 350°C at a temperature increase rate of 10°C/min and calcined at 350°C for 2 hours (first calcination step). After calcination, the sample was cooled to below 50°C. The absorption peak derived from silanol groups observed at 930 cm⁻¹ to 950 cm⁻¹ in the IR spectrum of the obtained aluminosilicate-based phosphor intermediate 2 had a higher intensity compared to the absorption peak derived from silanol groups observed at 930 cm⁻¹ to 950 cm⁻¹ in the IR spectrum of the raw material aluminosilicate. Here, the weight absolute humidity inside the furnace is less than 23 g/kg (DA). Thereafter, without removing the alumina boat from the electric furnace for calcination, the temperature was raised from room temperature to 500°C at a temperature increase rate of 10°C/min and calcined at 500°C for 2 hours. After this calcination, the sample was cooled to room temperature to obtain the phosphor of Example 8.

### <Comparative Example 1>

The phosphor of Comparative Example 1 was obtained by circulating nitrogen gas in the furnace instead of the air used in Example 7, with the other conditions being the same as in Example 7.

### <Comparative Example 2>

The phosphor of Comparative Example 2 was obtained by circulating a mixed gas of 4% hydrogen/nitrogen in the furnace instead of the air used in Example 7, with the other conditions being the same as in Example 7.

### <Comparative Example 3>

As a starting material, 1.0 g of commercially available NH₄-type Y-type zeolite manufactured by Sigma-Aldrich (product name: Molecular sieves, empirical formula: (NH₄)_{6.64}Na_{1.47}Al₅.₉₂Si_{16.04}O₄₈ ·19.2H₂O, Si/Al ratio: 2.7) was weighed and placed on an alumina boat. Next, the alumina boat was placed on a boat stand in an electric furnace for calcination, and air was circulated in the furnace at a flow rate of 0.25 L/min. Thereafter, the temperature was raised from room temperature to 350°C at a temperature increase rate of 10°C/min and calcined at 350°C for 6 hours. After calcination, the sample was cooled to room temperature to obtain the phosphor of Comparative Example 3.

### <Comparative Example 4>

As a starting material, 1.0 g of commercially available NH₄-type Y-type zeolite manufactured by Sigma-Aldrich (product name: Molecular sieves, empirical formula: (NH₄)_{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and air was circulated in the furnace at a flow rate of 0.25 L/min. Thereafter, the temperature was raised from room temperature to 350°C at a temperature increase rate of 10°C/min and calcined at 350°C for 12 hours. After calcination, the sample was cooled to room temperature to obtain the phosphor of Comparative Example 4.

### <Comparative Example 5>

As a starting material, 1.0 g of commercially available NH₄-type Y-type zeolite manufactured by Sigma-Aldrich (product name: Molecular sieves, empirical formula: (NH₄)_{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and nitrogen gas was circulated in the furnace at a flow rate of 0.25 L/min. Thereafter, the temperature was raised from room temperature to 350°C at a temperature increase rate of 10°C/min and calcined at 350°C for 2 hours (first calcination step). After calcination, the sample was cooled to below 50°C. Without removing the alumina boat from the electric furnace for calcination, the sample was recalcined under the same conditions as the first calcination step and then cooled to room temperature to obtain the phosphor of Comparative Example 5.

### <Comparative Example 6>

As a starting material, 1.0 g of commercially available NH₄-type Y-type zeolite manufactured by Sigma-Aldrich (product name: Molecular sieves, empirical formula: (NH₄)_{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and a mixed gas of 4% hydrogen/nitrogen was circulated in the furnace at a flow rate of 0.25 L/min. Thereafter, the temperature was raised from room temperature to 350°C at a temperature increase rate of 10°C/min and calcined at 350°C for 2 hours (first calcination step). After calcination, the sample was cooled to below 50°C. Without removing the alumina boat from the electric furnace for calcination, the sample was recalcined under the same conditions as the first calcination step and then cooled to room temperature to obtain the phosphor of Comparative Example 6.

### <Comparative Example 7>

As a starting material, 1.0 g of commercially available NH₄-type Y-type zeolite manufactured by Sigma-Aldrich (product name: Molecular sieves, empirical formula: (NH₄)_{6.64}Na_{1.47}Al_{5.92}Si_{16.04}O₄₈ ·19.2H₂O, Si/Al ratio: 2.7) was weighed and placed on an alumina boat. Next, the alumina boat was placed on a boat stand in an electric furnace for calcination, and air was circulated in the furnace at a flow rate of 0.25 L/min. Thereafter, the temperature was raised from room temperature to 350°C at a temperature increase rate of 10°C/min and calcined at 350°C for 30 minutes. After calcination, the sample was cooled to room temperature to obtain the phosphor of Comparative Example 7.

### <Various Measurements and Evaluations>

Various characteristics and physical properties were measured and evaluated using the methods shown below.

### (Crystallinity Evaluation by XRD)

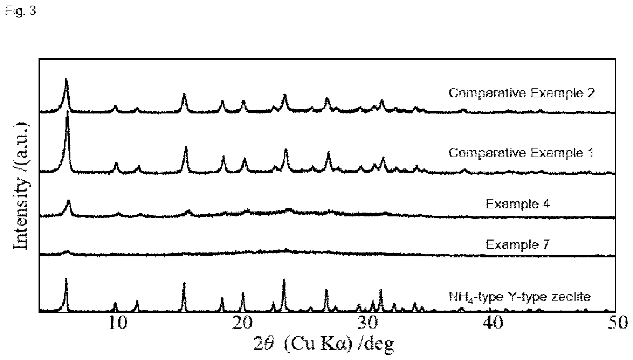

The XRD pattern of the phosphor obtained above was measured by powder X-ray diffraction using an X-ray diffractometer (XRD): RINT-Ultima+ manufactured by Rigaku Corporation. A part of the XRD pattern measurement results is shown in Fig. 3. The peak intensities of the obtained phosphor were compared with the respective peak intensities in the XRD pattern of the starting material, Sigma-Aldrich NH₄-type Y-type zeolite (product name: Molecular sieves, empirical formula: (NH₄)_{6.64}Na_{1.47}Al_{5.92}Si_{16.04}O₄₈·19.2H₂O, Si/Al ratio: 2.7). As in the XRD patterns of Example 4 and Example 7 in Fig. 3, when the peak intensity was significantly reduced, it was evaluated as "non-crystalline", and as in the XRD patterns of Comparative Example 1 and Comparative Example 2 in Fig. 3, when the peak intensity was not significantly reduced and the short-period structure of the crystal was maintained to some extent, it was evaluated as "crystalline."

### (Measurement of Absorption Peak Area by FT-IR)

The infrared absorption spectrum (IR spectrum) of the phosphor obtained above was measured by the KBr pellet method using a Fourier transform infrared spectrophotometer (FT-IR): IR Affinity-1S manufactured by Shimadzu Corporation. The absorption peak area derived from the νₛ vibration of Si-O-T observed at 1115 cm⁻¹ to 1190 cm⁻¹ was designated as S1, the absorption peak area derived from the δ vibration of O-Si-O observed at 490 cm⁻¹ to 520 cm⁻¹ as S2, the absorption peak area derived from the v vibration of D6R observed at 570 cm⁻¹ to 590 cm⁻¹ as S3, the absorption peak area derived from the v vibration of Si-OH observed at 930 cm⁻¹ to 950 cm⁻¹ as S4, and the absorption peak area derived from the νₛ vibration of T-O-T observed at 950 cm⁻¹ to 1065 cm⁻¹ as S0, and the respective peak areas S1/S0, S2/S0, S3/S0, and S4/S0 normalized by S0 were calculated.

### (Measurement of g-value by ESR)

The electron spin resonance spectrum (ESR spectrum) of the phosphor obtained above was measured using an electron spin resonance spectrometer (ESR): JES-FA200 manufactured by JEOL Ltd. The phosphor was packed into a quartz tube with a diameter of 5 mm and a length of 10 cm and subjected to X-band measurement. The g-value of each ESR spectrum was calculated by correcting the obtained ESR spectrum with a simultaneously measured Mn marker signal.

### (Fluorescence Lifetime Measurement)

The fluorescence lifetime of the phosphor obtained above was measured using a spectrofluorometer: FP-6500 manufactured by JASCO Corporation. The excitation light wavelength was set to 370 nm, the fluorescence wavelength to 400 nm, the sample was sufficiently irradiated with excitation light before measurement, and the shutter was set to close 10 milliseconds after the start of measurement. When the fluorescence lifetime was 1 millisecond or longer, which is a criterion for delayed fluorescence, it was evaluated as "A", and when it was less than 1 millisecond, it was evaluated as "B".

The results of various measurements and evaluations are shown in Tables 1 to 3.

| **Table 1** | | | **Example** | | | | |
|---|---|---|---|---|---|---|---|
| | | | **1** | **2** | **3** | **4** | **5** |
| **Production Method** | **First Calcination Step** | **Temperature** | **350°C** | **350°C** | **350°C** | **600°C** | **350°C** |
| | | **Time** | **2h** | **2h** | **2h** | **2h** | **2h** |
| | | **Atmosphere** | **Air** | **Nitrogen** | **4% Hydrogen/ Nitrogen** | **Air** | **Nitrogen** |
| | **Silanol Group Formation Step** | **Temperature** | **<50°C** | **<50°C** | **<50°C** | **<50°C** | **<50°C** |
| | | **Method for Contacting with Water** | **Water Addition** | **Water Addition** | **Water Addition** | **Water Addition** | **Moist Gas** |
| | | **Humidity** | **>23g/kg(DA)** | **>23g/kg(DA)** | **>23g/kg(DA)** | **>23g/kg(DA)** | **>23g/kg(DA)** |
| | **Second Calcination Step** | **Temperature** | **350°C** | **350°C** | **350°C** | **600°C** | **350°C** |
| | | **Time** | **2h** | **2h** | **2h** | **2h** | **2h** |
| | | **Atmosphere** | **Air** | **Nitrogen** | **4% Hydrogen/ Nitrogen** | **Air** | **Nitrogen** |
| | **Third Calcination Step** | **Temperature** | **-** | **-** | **-** | **-** | **-** |
| | | **Time** | **-** | **-** | **-** | **-** | **-** |
| | | **Atmosphere** | **-** | **-** | **-** | **-** | **-** |
| **Evaluation Result** | **XRD** | **Crystallinity** | **Non-crystalline** | **Non-crystalline** | **Non-crystalline** | **Non-crystalline** | **Non-crystalline** |
| | **FT-IR** | **SO (T-O-T vₛ vibration)** | **23.03** | **18.35** | **34.13** | **40.94** | **50.05** |
| | | **S1 (Si-O-T vₛ vibration)** | **8.556** | **7.119** | **13.43** | **14.94** | **19.34** |
| | | **S2 (O-Si-O δ vibration)** | **2.032** | **1.600** | **2.937** | **3.660** | **4.421** |
| | | **S3 (v vibration of D6R derived from zeolite structure)** | **3.019** | **2.342** | **4.382** | **5.266** | **6.571** |
| | | **S4 (v vibration of Si-OH)** | **2.322** | **1.738** | **3.244** | **4.443** | **5.421** |
| | | **S1/S0** | **0.371** | **0.388** | **0.393** | **0.365** | **0.386** |
| | | **S2/S0** | **0.088** | **0.087** | **0.086** | **0.089** | **0.088** |
| | | **S3/S0** | **0.131** | **0.128** | **0.128** | **0.129** | **0.131** |
| | | **S4/S0** | **0.101** | **0.095** | **0.095** | **0.109** | **0.108** |
| | **ESR** | **g-value** | **2.003** | **2.002** | **2.002** | **2.002** | **2.002** |
| | **Delayed Fluorescence** | | **A** | **A** | **A** | **A** | **A** |

N

| **Table 2** | | | **Example** | | | **Comparative Example** | |
|---|---|---|---|---|---|---|---|
| | | | **6** | **7** | **8** | **1** | **2** |
| **Production Method** | **First Calcination Step** | **Temperature** | **350°C** | **350°C** | **350°C** | **350°C** | |
| | | **Time** | **2h** | **2h** | **2h** | **2h** | **2h** |
| | | **Atmosphere** | **4% Hydrogen/ Nitrogen** | **Air** | **Air** | **Nitrogen** | **4% Hydrogen/ Nitrogen** |
| | **Silanol Group Formation Step** | **Temperature** | **<50°C** | **<50°C** | **<50°C** | **-** | **-** |
| | | **Method for Contacting with Water** | **Moist Gas** | **Air** | **Air** | **-** | **-** |
| | | **Humidity** | **>23g/kg(DA)** | **<23g/kg(DA)** | **<23g/Kg(DA)** | **-** | **-** |
| | **Second Calcination Step** | **Temperature** | **350°C** | **350°C** | **500°C** | **350°C** | **350°C** |
| | | **Time** | **2h** | **2h** | **2h** | **2h** | **2h** |
| | | **Atmosphere** | **4% Hydrogen/ Nitrogen** | **Air** | **Air** | **Nitrogen** | **4% Hydrogen/ Nitrogen** |
| | **Third Calcination Step** | **Temperature** | **-** | **350°C** | **-** | **350°C** | **350°C** |
| | | **Time** | **-** | **2h** | **-** | **2h** | **2h** |
| | | **Atmosphere** | **-** | **Air** | **-** | **Nitrogen** | **Hydrogen** |
| **Evaluation Result** | **XRD** | **Crystallinity** | **Non-crystalline** | **Non-crystalline** | **Non-crystalline** | **Crystal** | **Crystal** |
| | **FT-IR** | **S0 (T-O-T vₛ vibration)** | **45.23** | **49.48** | **76.06** | **40.81** | **22.23** |
| | | **S1 (Si-O-T vₛ vibration)** | **17.32** | **18.35** | **28.70** | **17.37** | **9.296** |
| | | **S2 (O-Si-O δ vibration)** | **3.934** | **4.395** | **6.758** | **4.522** | **2.468** |
| | | **S3 (v vibration of D6R derived from zeolite structure)** | **5.826** | **6.469** | **10.02** | **6.065** | **3.151** |
| | | **S4 (v vibration of Si-OH)** | **4.891** | **5.360** | **7.603** | **3.013** | **1.613** |
| | | **S1/S0** | **0.383** | **0.371** | **0.377** | **0.426** | **0.418** |
| | | **S2/S0** | **0.087** | **0.089** | **0.089** | **0.111** | **0.111** |
| | | **S3/S0** | **0.129** | **0.131** | **0.132** | **0.149** | **0.142** |
| | | **S4/S0** | **0.108** | **0.108** | **0.100** | **0.074** | **0.073** |
| | **ESR** | **g-value** | **2.002** | **2.003** | **2.003** | **2.003, 1.998, 1.979** | **2.001, 1.977** |
| | **Delayed Fluorescence** | | **A** | **A** | **A** | **B** | **B** |

| **Table 3** | | | **Comparative Example** | | | | |
|---|---|---|---|---|---|---|---|
| | | | **3** | **4** | **5** | **6** | **7** |
| **Production Method** | **First Calcination Step** | **Temperature** | **350°C** | **350°C** | **350°C** | **350°C** | **350°C** |
| | | **Time** | **6h** | **12h** | **2h** | **2h** | **30min** |
| | | **Atmosphere** | **Air** | **Air** | **Nitrogen** | **4% Hydrogen/ Nitrogen** | **Air** |
| | **Silanol Group Formation Step** | **Temperature** | **<50°C** | **<50°C** | **-** | **-** | **<50°C** |
| | | **Method for Contacting with Water** | **Moist Gas** | **Moist Gas** | **-** | **-** | **Air** |
| | | **Humidity** | **<23g/kg(DA)** | **<23g/kg(DA)** | **-** | **-** | **<23g/Kg(DA)** |
| | **Second Calcination Step** | **Temperature** | **-** | **-** | **350°C** | **350°C** | **-** |
| | | **Time** | **-** | **-** | **2h** | **2h** | **-** |
| | | **Atmosphere** | **-** | **-** | **Nitrogen** | **4% Hydrogen/ Nitrogen** | **-** |
| | **Third Calcination Step** | **Temperature** | **-** | **-** | **-** | **-** | **-** |
| | | **Time** | **-** | **-** | **-** | **-** | **-** |
| | | **Atmosphere** | **-** | **-** | **-** | **-** | **-** |
| **Evaluation Result** | **XRD** | **Crystallinity** | **Crystal** | **Crystal** | **Crystal** | **Crystal** | **Crystal** |
| | **FT-IR** | **S0 (T-O-T vₛ vibration)** | **49.24** | **38.82** | **51.19** | **65.57** | **31.4** |
| | | **S1 (Si-O-T vₛ vibration)** | **20.13** | **16.18** | **21.53** | **28.96** | **12.56** |
| | | **S2 (O-Si-O δ vibration)** | **5.846** | **4.624** | **5.643** | **7.223** | **3.056** |
| | | **S3 (v vibration of D6R derived from zeolite structure)** | **6.823** | **5.401** | **7.474** | **9.257** | **4.956** |
| | | **S4 (v vibration of Si-OH)** | **3.859** | **3.077** | **3.643** | **4.383** | **2.433** |
| | | **S1/S0** | **0.409** | **0.417** | **0.421** | **0.442** | **0.400** |
| | | **S2/S0** | **0.119** | **0.119** | **0.110** | **0.110** | **0.097** |
| | | **S3/S0** | **0.139** | **0.139** | **0.146** | **0.141** | **0.158** |
| | | **S4/S0** | **0.078** | **0.079** | **0.071** | **0.067** | **0.077** |
| | **ESR** | **g-value** | **2.003, 1.990, 1.980** | **2.003, 1.990, 1.980** | **2.003, 1.998, 1.979** | **2.002, 1.978** | **2.003, 1.998, 1.978** |
| | **Delayed Fluorescence** | | **B** | **B** | **B** | **B** | **B** |

0.365 to 0.400 and S2/S0 of 0.085 to 0.090 in the IR spectrum, have only one g-value obtained when electron spin resonance is measured, the g-value is 2.002 to 2.005, and exhibit delayed fluorescence. On the other hand, from the results in Tables 2 and 3, it can be seen that the phosphors according to Comparative Examples are crystalline, at least one of S1/S0 and S2/S0 does not satisfy the above ranges in the IR spectrum, have two or more g-values when electron spin resonance is measured, and do not exhibit delayed fluorescence.

### <Application Example of Phosphor>

### (Fabrication of White LED)

The A liquid and B liquid (KER-2500A and KER-2500B), which are two-liquid mixture type silicone resin encapsulant for LEDs manufactured by Shin-Etsu Silicone Co., Ltd., were mixed in a mass ratio of 1:1, and 0.2 g of the phosphor produced in Example 7 was added thereto and thoroughly stirred, and the mixture was applied in a dome shape onto an ultraviolet LED (peak wavelength: 410 nm) with the lens material cut off. Thereafter, a white LED was fabricated by heating and solidifying it at 100°C for 1 hour and then at 150°C for 5 hours using a dryer: ETTAS EO-300B manufactured by AS ONE

### CORPORATION.

### (Light Emission of White LED)

By applying a voltage of 3 V and a current of 16 mA to the white LED fabricated as described above, it was visually confirmed that the white LED emitted white light.

### (Durability Test of White LED)

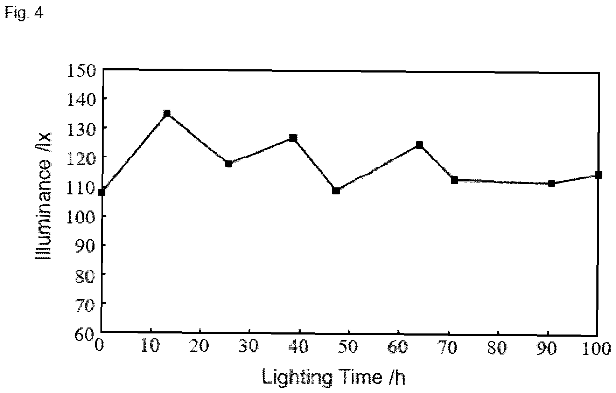

The white LED fabricated as described above was subjected to a durability test in which it was continuously lit for 100 hours under the conditions of a voltage of 3 V and a current of 16 mA. For the measurement of illuminance, an illuminance meter attached to a digital multimeter: MT-8210 from Mother Tool Co., Ltd. was used. Stray light was prevented from entering, and the photosensitive part of the illuminance meter was placed 1 cm away in the light emission direction of the LED, and the measurement was performed three times to calculate the average value. The measurement results are shown in Fig. 4.

From the results in Fig. 4, it can be seen that the illuminance never fell below 100 1x during 100 hours of continuous lighting, and the fabricated white LED has excellent durability.

### Reference Signs List

1a: single four-membered ring (S4R), 1b: single six-membered ring (S6R), 1c: double four-membered ring (D4R), 1d: double six-membered ring (D6R), 2: electric furnace for calcination, 20: furnace chamber, 21: gas inlet, 22: gas outlet, 23: boat stand, 24: alumina boat, 25: quartz tube, 26a, 26b: heater, 27a, 27b: thermocouple, 28: data logger, 29a, 29b: heat diffusion preventing inner lid

## Claims

1. A method for producing an aluminosilicate-based phosphor, comprising: a first calcination step, a silanol group formation step, and a second calcination step, wherein:
in the first calcination step, a raw material aluminosilicate having an SiO₄ tetrahedral structure is heated to form oxygen vacancies in the raw material aluminosilicate, thereby obtaining an aluminosilicate-based phosphor intermediate 1;
in the silanol group formation step, a temperature of the aluminosilicate-based phosphor intermediate 1 is lowered, and the aluminosilicate-based phosphor intermediate 1 is brought into contact with water to form silanol groups, thereby obtaining an aluminosilicate-based phosphor intermediate 2; and
in the second calcination step, the aluminosilicate-based phosphor intermediate 2 is heated to make the aluminosilicate-based phosphor intermediate 2 non-crystalline, thereby obtaining the aluminosilicate-based phosphor.

2. The method for producing an aluminosilicate-based phosphor of Claim 1, wherein in the silanol group formation step, the temperature of the aluminosilicate-based phosphor intermediate 1 is lowered to less than 50°C.

3. The method for producing an aluminosilicate-based phosphor of Claim 1 or 2, wherein:
a heating temperature of the raw material aluminosilicate in the first calcination step is 130°C to 600°C; and
a heating temperature of the aluminosilicate-based phosphor intermediate 2 in the second calcination step is equal to or higher than the heating temperature of the raw material aluminosilicate in the first calcination step.

4. The method for producing an aluminosilicate-based phosphor of Claim 1 or 2, wherein:
a heating time in the first calcination step is at least 30 minutes, and:
a heating time in the second calcination step is longer than the heating time in the first calcination step.

5. The method for producing an aluminosilicate-based phosphor of Claim 1 or 2, wherein in the silanol group formation step, a moist gas containing moisture is brought into contact with the aluminosilicate-based phosphor intermediate 1.

6. The method for producing an aluminosilicate-based phosphor of Claim 5, wherein in the second calcination step, the aluminosilicate-based phosphor intermediate 2 is heated in the moist gas.

7. The method for producing an aluminosilicate-based phosphor of Claim 5, wherein the moist gas has a weight absolute humidity of greater than 23 g/kg (DA).

8. An aluminosilicate-based phosphor, wherein:
the aluminosilicate-based phosphor is non-crystalline;
in an IR spectrum of the aluminosilicate-based phosphor measured by FT-IR, S1/S0 is 0.365 to 0.400 and S2/S0 is 0.085 to 0.090, where S1 is an absorption peak area derived from a νₛ vibration of Si-O-T observed at 1115 cm⁻¹ to 1190 cm⁻¹, S2 is an absorption peak area derived from a δ vibration of O-Si-O observed at 490 cm⁻¹ to 520 cm⁻¹, and S0 is an absorption peak area derived from a νₛ vibration of T-O-T observed at 950 cm⁻¹ to 1065 cm⁻¹;
the aluminosilicate-based phosphor has only one g-value obtained when its electron spin resonance is measured; and
the g-value is 2.002 to 2.005.

9. A light-emitting device, comprising the aluminosilicate-based phosphor of Claim 8 and a light-emitting body.

10. The light-emitting device of Claim 9, wherein the light-emitting body is a light-emitting element having an emission peak wavelength in a range of 250 nm to 480 nm.
